# EUROPÄISCHE PATENTSCHRIFT

(11) **EP 2 642 255 B1**
(45) Veröffentlichungstag und Bekanntmachung des Hinweises auf die Patenterteilung: **14.06.2023**
(21) Anmeldenummer: 13158799.0
(22) Anmeldetag: 12.03.2013
(51) Int. Cl.: G01D 11/24

(54) **Messgerät**
Measuring apparatus
Appareil de mesure

(30) Priorität: 22.03.2012 DE 102012005637
(43) Veröffentlichungstag der Anmeldung: 25.09.2013
(73) Patentinhaber: Krohne Messtechnik GmbH, 47058 Duisburg (DE)
(72) Erfinder: Matt, Achim, 47055 Duisburg (DE)
(74) Vertreter: Gesthuysen Patentanwälte

(56) Entgegenhaltungen:
- EP-A1- 0 945 714
- EP-A1- 1 130 363
- EP-B1- 1 000 310
- WO-A1-99/23725
- WO-A1-2011/079896
- WO-A2-2011/031609
- DE-A1-102010 030 924

## Beschreibung

Die Erfindung betrifft ein Messgerät gemäß dem Oberbegriff von Patentanspruch 1.

Für die Realisierung einer in Bezug auf die Messprinzipien und auch auf die Dimensionierungen oder Schutzklassen usw. großen Bandbreite von unterschiedlichen Messgeräten werden gelegentlich sogenannte Baukästen oder Baukastensysteme verwendet. Dabei werden die betroffenen Messgeräte ähnlich konstruiert und möglichst aus untereinander austauschbaren Komponenten zusammengestellt. Dies hat zum einen den Vorteil eines einheitlichen und einen Wiedererkennungswert aufweisenden Aussehens. Zum anderen reduzieren sich dadurch die Kosten bei der Herstellung bzw. ergibt sich eine größere Flexibilität für die Anpassung der Messgeräte an konkrete Anforderungen. Hierfür werden die Messgeräte zumeist in einzelne miteinander kombinierbare Komponenten aufgeteilt, die selbst wiederum modular aufgebaut sein können.

Bei Messgeräten ist dabei eine mögliche Trennung diejenige zwischen einer Sensoreinheit, in der das Messprinzip für die eigentliche Messung der Prozessgröße realisiert ist, und einer Elektronikeinheit, die der Auswertung oder Verarbeitung des Roh- oder Messwertes dient, den die Sensoreinheit erzeugt. Dabei kann die Sensoreinheit ggf. auch über eigene Elektronikkomponenten verfügen, die der Messung oder der Aus- bzw. Umwandlung der Rohwerte dienen. Sowohl die Sensor- als auch die Elektronikeinheit sind dabei üblicherweise in einem jeweiligen Gehäuse angeordnet, wobei das Gehäuse der Sensoreinheit ggf. eine Öffnung für einen direkten Kontakt mit dem zu messenden Messmedium und das Gehäuse der Elektronikeinheit wenigstens eine Öffnung für eine Energieversorgung bzw. eine Übermittlung der Messwerte z. B. an eine übergeordnete Einheit aufweisen. Weiterhin sind die beiden Gehäuse üblicherweise derartig ausgestaltet, dass sie sich miteinander verbinden lassen und dass es auch zu einer Energie- bzw. Signalübertragung zwischen der Sensor- und der Elektronikeinheit kommen kann.

Eine Elektronikeinheit lässt sich weiterhin in mehrere Module aufteilen, die ggf. auch beliebig miteinander austauschbar oder kombinierbar sind. Unterteilungen sind dabei möglich in eine zentrale Einheit, die der Energieversorgung, der Steuerung, der Messung und der Verarbeitung der Signale der Sensoreinheit in Ausgebesignale dient, in eine Anschluss- oder Konvertereinheit, die dem Anschluss des Messgerätes dient, und in ggf. an eine Anzeige- oder Bedieneinheit, die der Anzeige der Messwerte bzw. dem Bedienen des Messgerätes vor Ort dient.

Je nach Grad der Modularisierung können beliebige Anschlüsse für unterschiedliche Bussysteme mit beliebigen Anzeigeeinheiten und unterschiedlichen Sensortypen kombiniert werden. Eine modulare Ausgestaltung der Elektronikeinheit wird beispielsweise gezeigt in den Offenlegungsschrift DE 10 2006 009 827 A1 oder DE 10 2009 054 649 A1 oder in der Patentschrift DE 197 82 057 B4. Die Offenlegungsschrift DE 101 26 654 A1 beschreibt ein Gehäuse eines Messgerätes mit einem Anzeige- und einem davon separaten Anschlussraum für die Aufnahme eines Anzeige- bzw. eines Anschlussmoduls. Einen ähnlichen Aufbau offenbart die Patentschrift EP 0 775 292 B1 mit einem Gehäuse, das über zwei durch eine Wand mit einem Durchbruch getrennte Räume verfügt. Die Elektronikkomponenten in den Räumen sind durch Signalstifte miteinander kontaktiert, die in dem Durchbruch vergossen angeordnet sind. In der Gebrauchsmusterschrift DE 203 14 618 U1 befindet sich eine Stiftleiste vergossen innerhalb eines Durchführungsraums zwischen zwei Teilräumen des Gehäuses. Eine weitere Ausgestaltung eines Gehäuses und der darin befindlichen modularen Elektronikkomponenten nennt das Dokument WO 2011/160949 A1. Steckkontakte innerhalb eines vergossenen Messgerätes, die direkt an eine Elektronikkomponente anschließen und der Verbindung zu anderen Elektronikelementen dienen, offenbart beispielsweise die Offenlegungsschrift DE 102 33 296 A1.

In vielen Anwendungen wird von den Messgeräten Eigensicherheit gefordert. Die Zündschutzart "Eigensicherheit" beruht insbesondere auf einer Begrenzung der elektrischen Energie innerhalb der Elektronik des Messgerätes bzw. innerhalb von Abschnitten davon und der elektrischen Energie von Verbindungsleitungen auf ein Niveau unterhalb des Niveaus, bei dem im Kontakt mit einer explosionsfähigen Atmosphäre eine Zündung hervorgerufen werden kann. Eine wesentliche Anforderung, die sich aus den relevanten Normen ergibt, ist dabei die Einhaltung von Trennabständen zwischen leitfähigen Komponenten. Der Trennabstand ist dabei der kürzeste Abstand zwischen zwei solchen Komponenten. Unterschieden wird nach der Art des Mediums, durch das der Weg des kürzesten Abstandes führt, so dass sich unterschiedliche Trennabstände für Luftstrecken, Abstände im Verguss, Abstände durch feste Isolierung, Kriechstrecken in Luft oder Kriechstrecken unter einer Schutzschicht ergeben. Zudem hängen die einzuhaltenden Trennabstände von den maximal auftretenden Spannungen zwischen den leitfähigen Komponenten ab.

Details zur Ausgestaltung von modularen Elektronikkomponenten und deren Gehäusen für einen möglichen Einsatz in einem Baukasten für Messgeräte finden sich ebenfalls im Stand der Technik. So beschreibt die Offenlegungsschrift DE 10 2010 033 470 A1 ein Bedienfeld für Messgeräte und die Offenlegungsschrift DE 41 09 475 A1 ein drehbares Display. Eine drehbare mechanische Verbindung zwischen der Sensoreinheit und dem Gehäuse der Elektronikeinheit zeigt die Offenlegungsschrift DE 10 2004 044 890 A1. Eine wechselbare Verbindung zwischen der Sensoreinheit über eine Art Stecker mit einem Feldbus oder alternativ mit einem Programmiergerät ist der Offenlegungsschrift DE 103 27 013 A1 zu entnehmen. Weitere Einzelheiten wie das erleichterte Einführen eines Kabels in ein Gehäuse (z. B. die Patentschrift DE 10 2007 036 484 B3), das Erzeugen eines hartmetallischen Gewindes innerhalb eines Aluminiumgehäuses (z. B. die Patentschrift US 3,462,539), das Umgeben von Anschlussdrähten in einem Gerät mit Keramik- oder Glashülsen (z. B. die Gebrauchsmusterschrift DE 20 2010 007 043 U1), das Fixieren von Elektronikbauteilen über konische Schrägen im Gehäuse (z. B. die Offenlegungsschrift DE 10 2005 024 259 A1) oder besondere Vorrichtungen an der Außenseite des Gehäuses für Plombierungen (z. B. die Offenlegungsschrift DE 10 2010 003 743 A1) lassen sich ebenfalls schon im Stand der Technik finden und können zur Ausgestaltung von Messgeräten und deren Gehäusen beitragen.

Ein gattungegemäßes Messgerät ist aus der EP 1 130 363 A1 bekannt. Die EP 0 945714 A1 offenbart ein Messgerätegehäuse mit mehreren Kammern, die über einen Durchgang verbunden sind, wobei der Durchgang mit einer bekannten druckdichten Durchführung ausgestattet ist. Aus der DE 10 2010 030 924 ist ein Messgerätegehäuse mit mehreren Kammern und einem Zwischenboden bekannt. Die WO 20111/079896 A1 offenbart ein Sensorgehäuse mit zwei Kammern, wobei eine elektrische Verbindung zwischen den Kammern realisiert ist durch eine in dem Gehäuse vergossene Leiterplatte. Die WO 99/23725 A1 offenbart einen explosionsicheren Durchführungsstecker.

Der Erfindung liegt die Aufgabe zugrunde, ein Messgerät vorzuschlagen, dessen Elektronik modular aufgebaut ist und eine einfache Anpassung an den Eigenschutz erlaubt.

Die aufgezeigte Aufgabe ist erfindungsgemäß zunächst und im Wesentlichen bei dem in Rede stehenden Messgerät mit den Merkmalen des Kennzeichnungsteils von Patentanspruch 1 gelöst.

Bekannt ist, dass ein verkapseltes Kontaktierungselement vorgesehen ist. Das Kontaktierungselement ist dabei von den Elektronikeinrichtungen und dem Gehäuse separat ausgestaltet und zwischen den zwei Elektronikeinrichtungen angeordnet. Weiterhin weist das Kontaktierungselement mindestens ein elektronisches Übertragungselement zur Erzeugung einer elektrischen Verbindung zwischen den zwei Elektronikeinrichtungen auf.

Im Stand der Technik ist es bekannt, dass sich Elektronikeinrichtungen in durch eine Wand getrennten Kammern eines Gehäuses befinden und dass die Elektronikeinrichtungen durch Übertragungselemente wie z. B. Kontaktstifte miteinander kontaktiert werden, die in einem Durchbruch der Wand angeordnet und dort vergossen sind. D. h. ein solches Kontaktierungselement ist quasi Bestandteil der Wand des Gehäuses. Weiterhin ist es bekannt, dass einzelne Elektronikeinrichtungen über entsprechende Übertragungselemente verfügen und dass für den Explosionsschutz die gesamte Elektronikeinheit vergossen wird. Es ist ein separates Kontaktierungselement als eigenständiges Bauteil vorgesehen, das insbesondere bereits verkapselt ist - also an sich und für sich selbst verkapselt ist - und nicht erst innerhalb des Gehäuses verkapselt werden muss wie im Stand der Technik.

Ein solches bereits fertig einsetzbares Kontaktierungselement erlaubt neben der vereinfachten Anwendbarkeit auch die leichtere Anpassung an die verwendeten Gehäuse bzw. die Ausführungen der Elektroneinrichtungen. So kann der Abstand zwischen den Elektronikeinrichtungen leicht durch die Höhe des jeweils zwischen ihnen verwendeten Kontaktierungselements eingestellt werden. Da das Kontaktierungselement bereits verkapselt ist und es einer Verkapselung im Gehäuse nicht bedarf, lassen sich beim erfindungsgemäßen Messgerät auch defekte Komponenten leichter austauschen, da im einfachsten Fall nur die Steckverbindung zwischen einer Elektronikeinrichtung und dem Kontaktierungselement aufgehoben werden muss. Auch können relativ einfach unterschiedliche Anordnungen von mehreren Übertragungselementen, die ggf. auch komplexere Strukturen aufweisen, erzeugt werden, ohne dass es beispielsweise einer Abstützung im Gehäuse vor dem Vergießen wie im Stand der Technik bedürfte.

Weiterhin kann so auch eine abgewinkelte Anordnung der Elektronikeinrichtungen realisiert werden, indem das Kontaktierungselement einen passenden Winkel aufweist. Auch die Kontaktierung von mehr als zwei Elektronikeinrichtungen lässt sich realisieren, indem das Kontaktierungselement mehrere Übertragungselemente in unterschiedlichen Raumwinkeln aufweist. Da das Kontaktierungselement separat und bereits verkapselt ist, kann es als Teil eines Baukastensystems die Kombination von unterschiedlichen Elektronikeinrichtungen bzw. Gehäusen deutlich vereinfachen. Ein solches erfindungsgemäßes Messgerät ist dabei beispielsweise mit unterschiedlichen Sensoreinheiten verbunden, die z. B. der Durchflussmessung, der Füllstandsmessung, der pH-Wert- oder der Sauerstoffgehaltmessung dienen und beispielsweise als Coriolis-, als MID- oder als Radarfüllstandmessgerät gegeben sind.

Erfindungsgemäß sind mehrere Übertragungselemente (6) vorhanden, die als Kontaktierungsstifte realisiert sind. Durch solche Kontaktierungsstifte ist die Verbindung zwischen den Elektronikeinrichtungen einfach zu realisieren, indem dort die passenden Buchsen vorgesehen sind. In einer Ausgestaltung weist das Kontaktierungselement an beiden den Elektronikeinrichtungen zugewandten Seiten Kontaktierungsstifte auf bzw. es liegen durchgehende Kontaktierungsstifte vor. Es sind auch beliebige Kombinationen mit anderen Übertragungselementen, wie z. B. Steckern oder Kabeln möglich.

Erfindungsgemäß sind die Übertragungselemente (6) innerhalb einer Außenwandung des Kontaktierungselements vergossen und/oder eingeglast, wodurch das Kontaktierungselement (5) als eigenständiges Bauteil verkapselt ist. Diese Verkapselung bzw. das Einglasen dient dabei der Einstellung der für die Zündschutzart erforderlichen minimalen Abstände zwischen den stromführenden Leitern bzw. Kontaktierungselementen. Erfindungsgemäß sind mehrere Übertragungselemente vorgesehen, die alle innerhalb der Außenwandung des Kontaktierungselements vergossen und/oder eingeglast sind. Die Außenwandung als Teil der äußeren Hülle des Kontaktierungselements kann dabei zumindest teilweise aus Edelstahl oder einem Kunststoff bestehen. In einer Variante ist das Kontaktierungselement im Wesentlichen stopfen- oder pfropfenförmig ausgestaltet. Der Grundquerschnitt ist dabei insbesondere vorzugsweise kreisförmig, wobei jedoch keine Beschränkung auf diese Form besteht. In einer weiteren Ausgestaltung ist der Querschnitt des Kontaktierungselements asymmetrisch, so dass das Kontaktierungselement nur in einer definierten Orientierung in das Gehäuse einsetzbar ist, was automatisch zu definierten Einbau- und Kontaktierungspositionen - auch der verbundenen Elektronikeinrichtungen - führt.

Vorteilhafterweise sind das Kontaktierungselement und die zwei Elektronikeinrichtungen derartig ausgestaltet und aufeinander abgestimmt, dass das Kontaktierungselement und die zwei Elektronikeinrichtungen im Wesentlichen spaltfrei miteinander verbunden sind. Die Abmessungen der Elektronikeinrichtungen bzw. deren Gehäuse und des Kontaktierungselements sind daher derart, dass sie nach einer Verbindung untereinander spaltfrei sind. Vorzugsweise geschieht dies ohne zusätzliche Dicht- oder Vergusselemente. Für die Erhöhung der Sicherheit ist jedoch ein zusätzlicher Verguss bzw. sind zusätzliche Dichtelemente um das Kontaktierungselement bzw. die zwei Elektronikeinrichtungen herum möglich.

Das Gehäuse weist mindestens zwei Kammern auf, zwischen denen ein Durchgang besteht. Dabei ist in jeder Kammer eine der zwei Elektronikeinrichtungen und das Kontaktierungselement in dem Durchgang angeordnet. Das Kontaktierungselement ist dabei im erfindungsgemäßen Messgerät bereits verkapselt und entsteht nicht - wie im Stand der Technik - erst durch das Vergießen von beispielsweise Kontaktstiften, die durch einen solchen Durchgang hindurchgeführt sind. In einer Ausgestaltung ist das Kontaktierungselement passgenau in dem Durchgang angeordnet.

In weiteren Ausgestaltungen wird die Trennung zwischen den zwei Elektronikeinrichtungen bzw. zwischen den zwei Kammern verstärkt. Dabei ist in einer Ausgestaltung vorgesehen, dass das Kontaktierungselement im Durchgang zusätzlich zu seiner Verkapselung vergossen ist. Alternativ oder ergänzend ist vorgesehen, dass der Übergang zwischen mindestens einer Elektronikeinrichtung und dem Kontaktierungselement vergossen ist. Zusätzlich ist ebenfalls ergänzend oder alternativ zwischen mindestens einer Elektronikeinrichtung und dem Kontaktierungselement und/oder zwischen dem Kontaktierungselement und dem Durchgang mindestens eine Dichteinrichtung - insbesondere ein O-Ring - angeordnet. Alternativ kann auch der gesamte Innenraum des Gehäuses vergossen sein.

In einer Ausgestaltung wird insbesondere darauf eingegangen, dass Messgeräte in der Anwendung z. B. als Teil der Prozessautomatisierung manchmal starken mechanischen Belastungen ausgesetzt sind. Ist ein Messgerät beispielsweise an einem Behälter - ein Silo oder Tank - eines Mediums mit der Sensoreinheit angebracht, so kann das Befüllen des Behälters oder ein Rührwerk im Behälter zu Erschütterungen des Messgerätes und dadurch auch zu einer Belastung der elektronischen Bauteile bzw. der Kontaktierungen im Messgerät führen. Entsprechendes gilt, wenn das Messgerät an einem Rohr z. B. für die Messung des Durchflusses angebracht ist. Um die Auswirkungen solcher Schwingungen auf die Elektronikkomponenten herabzusetzen, ist die folgende Ausgestaltung vorgesehen, die jedoch auch unabhängig von der obigen Art der Ausgestaltung des Kontaktierungselements ist, gleichwohl aber eine sehr gute Kombination damit bildet, um ein möglichst optimales Messgerät zu realisieren.

Die Ausgestaltung besteht darin, dass das Gehäuse mindestens einen Elektronikzugang zu mindestens einer der zwei Elektronikeinrichtungen aufweist. Das Gehäuse verfügt daher über einen Zugang oder eine Öffnung, über die mindestens eine Elektronikeinrichtung erreichbar, insbesondere einbringbar ist. Durch den Elektronikzugang erstreckt sich insbesondere eine erste Längsachse. Ist beispielsweise der Abschnitt des Gehäuses, der sich an den Elektronikzugang anschließt und der vorzugsweise eine Elektronikeinrichtung umfasst, im Wesentlichen zylinderförmig - beispielweise mit einer kreisförmigen Grundfläche - ausgestaltet, so ist besagte erste Längsachse die Längsachse dieses zylindrischen Abschnitts. Mündet der Elektronikzugang allgemein auf eine Zugangsebene, d. h. schließt das Gehäuse in einer solchen Zugangsebene ab, so ist die erste Längsachse insbesondere die Normale auf dieser Zugangsebene, die sich mittig durch den Elektronikzugang erstreckt. Weiterhin verfügt das Gehäuse über einen Sensorzugang zur Anbindung einer Sensoreinheit. Die Sensoreinheit dient dabei der eigentlichen Messung oder Überwachung beispielsweise einer Prozessgröße wie Füllstand oder Durchfluss und liefert zumeist Rohwerte, die aus einer für die Messung bzw. Überwachung verwendeten Abhängigkeit einer messbaren Größe von der Prozessgröße entstehen. Für den Anschluss einer solchen Sensoreinheit an das Gehäuse ist ein Sensorzugang, also eine Öffnung für die Sensoreinheit vorgesehen. Dabei mündet der Sensorzugang in eine Anschlussebene. Da in vielen Anwendungen die Anbindung des Messgerätes an einen Behälter oder an ein Rohr usw. über einen Flansch geschieht, lässt sich eine solche Anschlussebene auch als Flanschebene bezeichnen. Durch den Sensorzugang erstreckt sich insbesondere eine zweite Längsachse. Ist auch dieser Abschnitt des Gehäuses, der sich an den Sensorzugang anschließt und der ggf. auch für die Kontaktierung mit der Sensoreinheit ausgestaltet ist, im Wesentlichen zylindrisch - ggf. ebenfalls mit einer kreisförmigen Grundfläche - ausgestaltet, so ist auch die zweite Längsachse die Längsachse dieses zylindrischen, dem Übergang zur Sensoreinheit dienenden Teils des Gehäuses. Die zweite Längsachse steht dabei insbesondere senkrecht auf der Anschlussebene.

In einer besonderen Ausgestaltung stehen die erste Längsachse und die zweite Längsachse senkrecht aufeinander, so dass das Gehäuse zumindest teilweise L- oder T-förmig ausgestaltet ist. Der Winkel zwischen der ersten und der zweiten Längsachse kann jedoch auch einen anderen Wert haben, so dass sich ggf. eine Y-Form ergibt, falls noch zumindest ein dritter Abschnitt im Gehäuse vorgesehen ist. In einer weiteren beispielhaften Ausgestaltung sind die Zugangsebene und die Anschlussebene abweichend zu einer parallelen Anordnung zueinander angeordnet. Die erste und die zweite Längsachse spannen insbesondere eine Orientierungsebene auf, die insbesondere senkrecht auf der Zugangs- und der Anschlussebene steht.

Weiterhin weist mindestens eine Elektronikeinrichtung mindestens eine Platine auf. Platinen werden zumeist zum Tragen der jeweiligen Elektronikbauteile verwendet. Die Platine liegt dabei im Wesentlichen in einer Platinenebene. Die Platine ist derartig im Gehäuse angeordnet, dass die Platinenebene in einem Winkel zur Orientierungsebene angeordnet ist, der sich von einem ganzzahligen Vielfachen von 90° unterscheidet. Handelt es sich bei dem Elektronikzugang um eine kreisförmige Öffnung und dient die Anschlussebene als Vorgabe eines gedachten Südpols, so ist die Platine in dieser Ausgestaltung weder in Nord-Süd- noch ein Ost-West-Richtung ausgerichtet. In einer Ausgestaltung ist die Platinenebene entlang den Winkelhalbierenden der Quadranten, also in Nordost-/Südwest- oder in Nordwest-/Südost-Richtung angeordnet. In einer weiteren Ausgestaltung ist zudem die Platinenebene in einem Winkel zur Anschlussebene angeordnet, der sich ebenfalls von einem ganzzahligen Vielfachen von 90° unterscheidet. Die Platinenebene ist daher vorzugsweise in dieser Ausgestaltung weder senkrecht zur Anschlussebene noch parallel dazu angeordnet. In einer weiteren Ausgestaltung ist die Platinenebene vorzugsweise in einem 45°-Winkel zur Anschlussebene angeordnet. Durch eine solche "schräge" Anordnung der Platine relativ zur Ebene des Anschlusses wird die bei Erschütterungen auf die Platine und deren Bestandteile wirkende Kraft vermindert, insbesondere durch die vektorielle Aufteilung wirkender Kräfte in die Platinenebene.

Im Einzelnen gibt es eine Vielzahl von Möglichkeiten, das erfindungsgemäße Messgerät auszugestalten und weiterzubilden. Dazu wird verwiesen einerseits auf die dem Patentanspruch 1 nachgeordneten Patentansprüche, andererseits auf die folgende Beschreibung von Ausführungsbeispielen in Verbindung mit der Zeichnung. In der Zeichnung zeigen
- Fig. 1: eine schematische, im Wesentlichen die grundlegende Anordnung verdeutlichende Darstellung eines Teils eines Messgerätes im Schnitt,
- Fig. 2: eine Draufsicht auf das Messgerät der Fig. 1,
- Fig. 3: eine räumliche Darstellung eines Gehäuses eines Messgerätes,
- Fig. 4: eine räumliche Darstellung eines Messgerätes und
- Fig. 5: eine räumliche Darstellung einer weiteren Variante des Gehäuses eines Messgerätes.

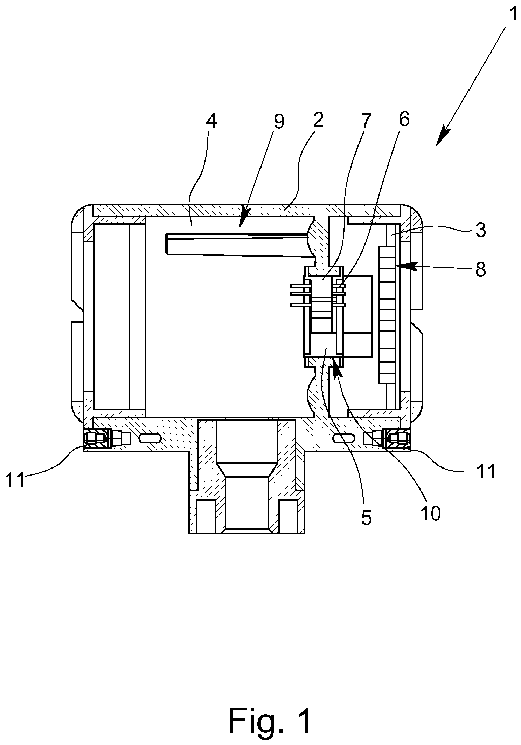

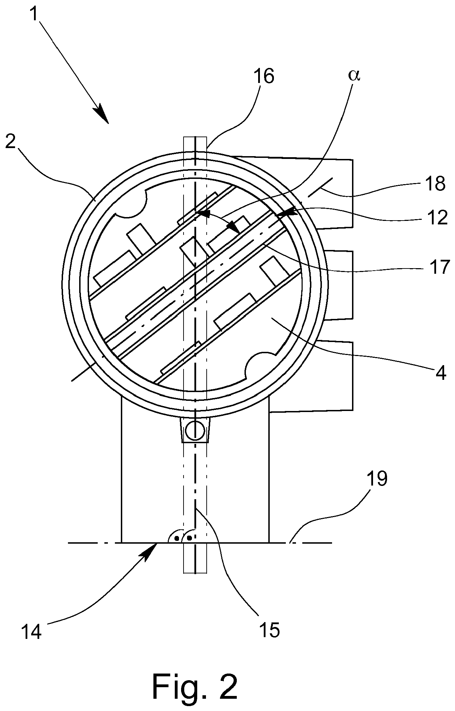

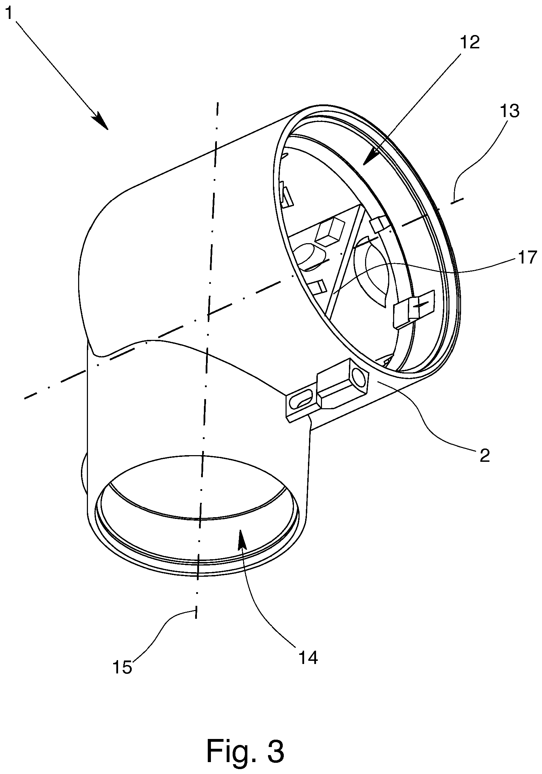

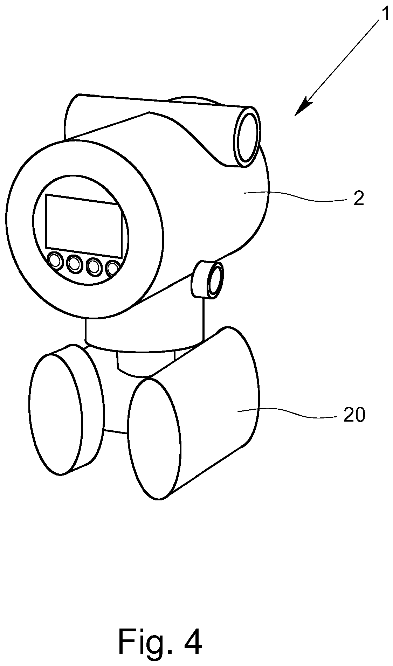

In der Fig. 1 ist ein Schnitt durch einen Teil eines schematisch dargestellten erfindungsgemäßen Messgerätes 1 und in der Fig. 2 eine Draufsicht darauf dargestellt. Die Fig. 3 bietet einen räumlichen Blick auf ein Gehäuse 2 eines Messgeräts 1. Eine andere Variante eines Gehäuses 2 als Teil eines Messgerätes 1 zeigt in räumlicher Darstellung die Fig. 4.

In der Fig. 1 ist ein Teil eines erfindungsgemäßen Messgerätes 1 dargestellt und zwar das Gehäuse 2, in dem sich die Elektronikeinheit befindet. Um ein vollständiges, funktionsfähiges Messgerät 1 zu erhalten, ist an den unteren Bereich des Gehäuses 2 lediglich noch eine entsprechende Sensoreinheit anzuschließen, in der das jeweils verwendete Messprinzip umgesetzt wird, um aus der zu messenden Prozessgröße (z. B. Durchfluss oder Füllstand) vorzugsweise eine elektrische Messgröße zu gewinnen. In dem Gehäuse 2 befinden sich hier zwei Elektronikeinrichtungen 3, 4, die in der dargestellten Umsetzung der Erfindung hintereinander angeordnet sind. Bei der größeren Elektronikeinrichtung 4 ist an der Wandung eine Führungsstruktur zu erkennen, durch die die Elektronikeinrichtung 4 leichter und sicher in das Gehäuse 2 bei der Montage eingebracht und wodurch eine Fehlmontage oder eine Beschädigung von Einzelteilen verhindert werden kann. Hierzu gehört auch, dass die Elektronikeinrichtung 4 bzw. die Innenwand des Gehäuses 2 konisch ausgestaltet sind. Die andere Elektronikeinrichtung 3 verfügt beispielsweise über mehrere Klemmenkontakte, die in Richtung der Innenwand des Gehäuses 2 angeordnet sind und es durch ihre teilweise mehrfache und insbesondere redundante Ausgestaltung erlauben, dass beispielsweise eine Anzeige- oder Bedieneinheit mit einer wählbaren Orientierung aufgesetzt und kontaktiert werden kann.

Zwischen den zwei Elektronikeinrichtungen 3, 4 ist das Kontaktierungselement 5 angeordnet, dass in sich gekapselt und insbesondere separat von den zwei Elektronikeinrichtungen 3, 4 ausgestaltet ist. Das Kontaktierungselement 5 dient dabei der elektrischen Verbindung zwischen den Elektronikeinrichtungen 3, 4 und auch der Trennung beider Elektronikeinrichtungen 3, 4, beispielsweise für die Gewährleistung der Eigensicherheit.

Für die Verbindung sind Übertragungselemente 6 vorgesehen, die hier in beide Richtungen als Stifte realisiert sind. Die Übertragungselemente 6 sind dabei innerhalb der Außenwandung 7, die hier aus Edelstahl besteht, des Kontaktierungselements 5 vergossen bzw. eingeglast, wobei für den Eigenschutz auf die erforderlichen Abstände zwischen den einzelnen Übertragungselementen 6 geachtet ist. In einer alternativen Ausgestaltung besteht die Außenwandung 7 aus einem Kunststoff bzw. aus einem Verbundwerkstoff. In der hier gezeigten Ausführung ist das Kontaktierungselement 5 stopfenförmig ausgestaltet.

Der Innenraum des Gehäuses 2 ist hier in zwei Kammern 8, 9 unterteilt, in denen sich jeweils eine Elektronikeinheit 3, 4 befindet. Getrennt sind die zwei Kammern 8, 9 durch eine Wand, die einen Durchgang 10 aufweist, der das Kontaktierungselement 5 beherbergt. Vorliegend sind der Durchgang 10 und das Kontaktierungselement 5 derartig ausgestaltet und aufeinander abgestimmt, dass das Kontaktierungselement 5 passgenau im Durchgang 10 angeordnet ist.

Am hier nach unten ragenden Hals des Gehäuses 2 wird insbesondere die jeweilige Sensoreinheit angebracht, z. B. durch eine Schraube fixiert. Durch die Anwendung von beispielsweise einem Bajonettverschluss kann jedoch auch eine Variante realisiert werden, in der die Sensoreinheit und das Gehäuse teilweise gegeneinander dreh- bzw. schwenkbar sind. Der untere Hals erlaubt beispielsweise auch das Einbringen von Kabeln oder z. B. flexiblen Leiterplatten, die von der - hier nicht dargestellten - Sensoreinheit ausgehen und die mit den Elektronikeinrichtungen 3, 4 zu verbinden sind.

Bei einer Montage eines erfindungsgemäßen Messgerätes 1 werden die Elektronikeinrichtungen 3, 4 und das Kontaktierungselement 5 in das Gehäuse 2 eingebracht und ineinander gesteckt. Verbinden sich dabei insbesondere das Kontaktierungselement 5 und die jeweilige Elektronikeinrichtung 3, 4 spaltfrei miteinander, so ist durch die Verkapselung des Kontaktierungselements 5 kein weiterer Verguss wie im Stand der Technik erforderlich. Die Verbindung durch das Stecken ist insbesondere reversibel, so dass auch im eingebauten Zustand noch einzelne Komponenten beispielsweise ausgetauscht werden können.

In der Fig. 1 sind weiterhin Gewindehülsen 11 zu erkennen, die in das Gehäuse 2 eingefügt, z. B. eingepresst sind. Diese Hülsen 11 sind vorliegend aus Edelstahl und lassen sich in ein Gehäuse 2 aus Aluminium oder Kunststoff einbringen, z. B. eindrehen oder einpressen.

Die Fig. 2 erlaubt einen Blick über den Elektronikzugang 12 in das Messgerät 1. Die erste Längsachse dieses Abschnitts erstreckt sich dabei bei der dargestellten Variante senkrecht in die Zeichnungsebene hinein. Die zu sehende Elektronikeinrichtung 4 weist mehrere Platinen oder Leiterplatten auf, von denen eine Platine 17 sich in einer Platinenebene 18 befindet. Dabei ist zu erkennen, dass sich auch die anderen Platinen in Ebenen parallel der Platinenebene 18 befinden. Am unteren Hals des Gehäuses 2 ist ein Sensorzugang 14 vorgesehen, der der Verbindung und Kontaktierung mit einer - hier nicht dargestellten - Sensoreinheit dient. Das Ende des Gehäuses 2 mündet dabei in einer Anschlussebene 19, auf der die zweite Längsachse 15 dieses Abschnitts des Gehäuses 2 senkrecht steht.

Von der ersten Längsachse und der zweiten Längsachse 15 wird eine Orientierungsebene 16 aufgespannt, die hier ebenfalls senkrecht zur Zeichnungsebene verläuft. Wie zu erkennen, ist die Platinenebene 18 in einem Winkel α = 45° gegenüber der Orientierungsebene 16 geneigt. Dabei sind jedoch auch andere Winkel α in anderen hier nicht dargestellten Ausgestaltungen realisiert. Gemein ist allen Varianten, dass der Winkel α sich von einem ganzzahligen Vielfachen von 90° unterscheidet, d. h. die Platinenebene 18 ist weder parallel zur Orientierungsebene 16 noch senkrecht dazu angeordnet. Die Platine 17 ist weiterhin auch in einem 45°-Winkel zur Anschlussebene 19 angeordnet. Auch bei dieser relativen Orientierung der Platine 17 oder Leiterplatte zur Anschlussebene 19 sind andere Winkel möglich, die jeweils zu einer Schräglage der Platine 17 führen. Diese Neigung gegenüber der Anschlussebene 19, über die zumeist die Anbringung des Messgerätes 1 an einem Behälter oder einem Rohr erfolgt, werden die Auswirkungen von Erschütterungen auf die Platine 17 bzw. deren Bauteile oder der Kontaktierungen der Bauteile reduziert.

In der dargestellten Variante ist weiterhin zu erkennen, dass das Gehäuse 2 noch drei weitere seitliche Zugänge beispielsweise für Kabelverbindungen aufweist.

Die Fig. 3 zeigt ein Gehäuse 2, in dem die erste Längsachse 13 des Elektronikzugangs 12 und die zweite Längsachse 15 des Sensorzugangs 14 eingezeichnet sind. In der dargestellten Variante bilden die beiden Längsachsen 13, 15 einen rechten Winkel miteinander und definieren folglich eine Orientierungsebene, die entsprechend als Symmetrieebene des Gehäuses 2 in Bezug auf die beiden betrachteten Abschnitte aufgefasst werden kann. Die hier bezüglich ihrer Lage angedeutete Platine 17 ist sichtbar gegenüber der von den beiden Längsachsen 13, 14 gebildeten Ebene geneigt. Unterhalb des Elektronikzugangs 12 ist noch die Ausformung zu erkennen, die es erlaubt, einen Deckel über eine Schraube am Gehäuse 2 zu befestigen und sogar eine Plombierung anzubringen.

Das Messgerät 1 der Fig. 4 besteht aus dem Gehäuse 2 und der Sensoreinheit 20. Beide sind beispielsweise über eine Verschraubung miteinander verbunden. Die konkret gezeigte Sensoreinheit 20 ist dabei nur ein Beispiel, und es lassen sich beliebige andere Arten von Sensoreinheiten 20 für die unterschiedlichen Messprinzipien an ein solches Gehäuse 2 anschließen. Wesentlich für die Kombination der unterschiedlichen Bauteilegruppen ist, dass die miteinander in Kontakt tretenden Abschnitte aufeinander abgestimmt sind, so ist beispielsweise für die Verbindung zwischen Gehäuse 2 und Sensoreinheit 20 auf passende Halsgeometrien zu achten. Besteht insbesondere zwischen Gehäuse 2 und Sensoreinheit 20 eine Verbindung über ein Gewinde, so kann über eine entsprechende Steigung bzw. eine entsprechende Anzahl von Gewindegängen zwischen beiden auch den Forderungen unterschiedlicher Explosionsschutznormen entsprochen werden.

Das Gehäuse 2 ist in der gezeigten Variante mit einem Deckel verschlossen, durch den hindurch ein Anzeige- und Bedienelement zu sehen ist. Für die Bedienung sind beispielsweise mechanische Tasten mit einer speziellen Folie vorgesehen. Alternativ lässt sich jedoch auch eine kapazitive oder induktive Tastatur realisieren, die auf die Näherung eines Fingers oder eines Stiftes reagiert. In einer weiteren Variante sind Hallsensoren im Gehäuse 2 vorgesehen, die mittels Magnetstiften durch einen geschlossenen Deckel bedient werden können und dadurch auch der Explosionsschutzanforderung entsprechen. Werden zwischen einem Display-Modul und der dahinterliegenden Elektroneinrichtung Kontaktstifte verwendet, so ist auch das Befestigen des Display-Moduls vereinfacht und es kann ggf. auch ein Drehen der Anzeigeeinheit gegenüber dem Gehäuse 2 einfach umgesetzt werden, indem beispielsweise die Anzahl der Kontaktstifte erhöht und die Kontaktstifte unter unterschiedlichen Raumwinkeln redundant ausgeführt werden. Dabei können bei der Anzeigeeinheit bzw. der zugeordneten Elektronikeinheit auch Stifte oder Buchsen variiert werden. Alternativ erfolgt die Kontaktierung über Kabel, so dass lediglich die Lagerung der Anzeige- bzw. Bedieneinheit unterschiedliche relative Einstellung erlauben muss.

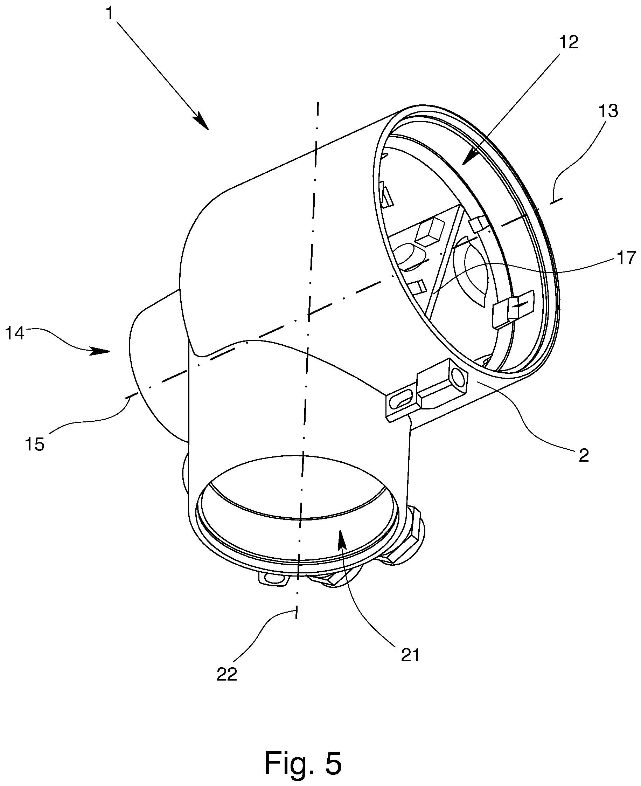

Im Gehäuse 2 des Messgeräts 1 der Fig. 5 fallen die erste Längsachse 13 des Elektronikzugangs 12 und die zweite Längsachse 15 des Sensorzugangs 14 zusammen, da in dieser Variante beide Zugänge 12, 14 fluchtend hintereinander angeordnet sind, wobei zwischen den Komponenten des Messgerätes 1 innerhalb des Gehäuses 2 eine Verbindung wie in der Fig. 1 dargestellt besteht. Von einer Elektronikeinrichtung ist hier eine Platine 17 vereinzelt zeichnerisch hervorgehoben, um dessen Orientierung besser zu erkennen. Das Gehäuse 2 verfügt zusätzlich über einen elektrischen Anschlussraum 21 mit einer dritten Längsachse 22, die im Wesentlichen senkrecht auf der ersten 13 bzw. zweiten Längsachse 15 angeordnet ist. Die dritte 22 und die erste 13 bzw. zweite Längsachse 15 spannen eine Ebene auf, zu der die Platinenebene der Platine 17 in einem Winkel unterschiedlich zu einem ganzzahligen Vielfachen von 90° angeordnet ist.

## Patentansprüche

1. Messgerät (1), mit mindestens einem Gehäuse (2) und mit mindestens zwei Elektronikeinrichtungen (3, 4), wobei das Gehäuse (2) mindestens zwei Kammern (8, 9) aufweist, zwischen denen ein Durchgang (10) besteht, wobei in jeder Kammer (8, 9) eine der zwei Elektronikeinrichtungen (3, 4) angeordnet ist, und wobei ein Kontaktierungselement (5) in dem Durchgang (10) angeordnet ist,
wobei das Kontaktierungselement (5) von den Elektronikeinrichtungen (3, 4) und dem Gehäuse (2) separat ausgestaltet ist, wobei das Kontaktierungselement (5) zwischen den zwei Elektronikeinrichtungen (3, 4) angeordnet ist, und wobei das Kontaktierungselement (5) mindestens ein elektronisches Übertragungselement (6) zur Erzeugung einer elektrischen Verbindung zwischen den zwei Elektronikeinrichtungen (3, 4) aufweist,
**dadurch gekennzeichnet,**
**dass** mehrere Übertragungselemente (6) vorhanden sind, die als Kontaktierungsstifte realisiert sind, und dass die Übertragungselemente (6) innerhalb einer Außenwandung (7) des Kontaktierungselements (5) vergossen und/oder eingeglast sind, wodurch das Kontaktierungselement (5) als eigenständiges Bauteil verkapselt ist, wodurch die für eine zu realisierende vorbestimmte Zündschutzart erforderlichen minimalen Abstände zwischen den Kontaktierungsstiften eingestellt sind.

2. Messgerät (1) nach Anspruch 1, **dadurch gekennzeichnet, dass** die Außenwandung (7) zumindest teilweise aus Edelstahl oder einem Kunststoff besteht.

3. Messgerät (1) nach Anspruch 1 oder 2, **dadurch gekennzeichnet, dass** das Kontaktierungselement (5) im Wesentlichen stopfenförmig ausgestaltet ist.

4. Messgerät (1) nach einem der Ansprüche 1 bis 3, **dadurch gekennzeichnet, dass** das Kontaktierungselement (5) und die zwei Elektronikeinrichtungen (3, 4) derartig ausgestaltet und aufeinander abgestimmt sind, dass das Kontaktierungselement (5) und die zwei Elektronikeinrichtungen (3, 4) im Wesentlichen spaltfrei miteinander verbunden sind.

5. Messgerät (1) nach einem der Ansprüche 1 bis 4, **dadurch gekennzeichnet, dass** das Kontaktierungselement (5) zusätzlich im Durchgang (10) vergossen ist, und/oder dass der Übergang zwischen mindestens einer Elektronikeinrichtung (3, 4) und dem Kontaktierungselement (5) vergossen ist, und/oder dass zwischen mindestens einer Elektronikeinrichtung (3, 4) und dem Kontaktierungselement (5) und/oder zwischen dem Kontaktierungselement (5) und dem Durchgang (10) mindestens eine Dichteinrichtung - insbesondere ein O-Ring - angeordnet ist.

6. Messgerät (1) nach einem der Ansprüche 1 bis 5, **dadurch gekennzeichnet, dass** das Gehäuse (2) mindestens einen Elektronikzugang (12) zu mindestens einem der zwei Elektronikeinrichtungen (3, 4) aufweist, wobei sich durch den Elektronikzugang (12) eine erste Längsachse (13) erstreckt, dass das Gehäuse (2) einen Sensorzugang (14) zur Anbindung einer Sensoreinheit (20) aufweist, wobei sich durch den Sensorzugang (14) eine zweite Längsachse (15) erstreckt, und wobei die erste Längsachse (13) und die zweite Längsachse (15) eine Orientierungsebene (16) aufspannen, dass mindestens eine Elektronikeinrichtung (4) mindestens eine Platine (17) aufweist, dass die Platine (17) im Wesentlichen in einer Platinenebene (18) liegt, und dass die Platine (17) derartig im Gehäuse (2) angeordnet ist, dass die Platinenebene (18) in einen Winkel (α) zur Orientierungsebene (16) angeordnet ist, der sich von einem ganzzahligen Vielfachen von 90° unterscheidet.

7. Messgerät (1) nach Anspruch 6, **dadurch gekennzeichnet, dass** der Sensorzugang (14) in einer Anschlussebene (19) mündet, und dass die Platine (17) derartig im Gehäuse (2) angeordnet ist, dass die Platinenebene (18) in einem Winkel zur Anschlussebene (19) angeordnet ist, der sich von einem ganzzahligen Vielfachen von 90° unterscheidet.

## Claims

1. Measuring device (1), having at least one housing (2) and having at least two electronic devices (3, 4), wherein the housing (2) has at least two chambers (8, 9) between which there is a passage (10), wherein one of the two electronic devices (3, 4) is arranged in each chamber (8, 9), and wherein a contacting element (5) is arranged in the passage (10),
wherein the contacting element (5) is formed separately from the electronic devices (3, 4) and the housing (2), wherein the contacting element (5) is arranged between the two electronic devices (3, 4), and wherein the contacting element (5) comprises at least one electronic transmission element (6) for generating an electrical connection between the two electronic devices (3, 4),
**characterized in**
**that** a plurality of transmission elements (6) are provided, which are implemented as contacting pins, and that the transmission elements (6) are molded and/or set in glass within the outer wall (7) of the contacting element (5), whereby the contacting element (5) is encapsulated as an independent component, whereby the minimum distances between the contacting pins required for a predetermined type of ignition protection to be implemented are set.

2. Measuring device (1) according to claim 1, **characterized in that** the outer wall (7) consists at least partially of stainless steel or a synthetic material.

3. Measuring device (1) according to claim 1 or 2, **characterized in that** the contact element (5) is essentially designed in a plug shape.

4. Measuring device (1) according to any one of claims 1 to 3, **characterized in that** the contact element (5) and the two electronic units (3, 4) are designed and attuned to one another in such a manner that the contact element (5) and the two electronic units (3, 4) are joined together essentially gap-free.

5. Measuring device (1) according to any one of claims 1 to 4, **characterized in that** the contact element (5) is molded additionally in the passage (10) and/or that the transition between at least one electronic unit (3, 4) and the contact element (5) is molded and/or that at least one sealing device - in particular an O-ring - is arranged between at least one electronic unit (3, 4) and the contact element (5) and/or between the contact element (5) and the passage (10).

6. Measuring device (1) according to any one of claims 1 to 5, **characterized in that** the housing (2) has at least one electronic access (12) to at least one of the two electronic units (3, 4), wherein a first longitudinal axis (13) extends through the electronic access (12), that the housing (2) has a sensor access (14) for connection to a sensor unit (20), wherein a second longitudinal axis (15) extends through the sensor access (14) and wherein the first longitudinal access (13) and the second longitudinal access (15) span an orientation plane (16), that at least one electronic unit (3, 4) has at least one printed circuit board (17), that the printed circuit board (17) lies essentially in a printed circuit board plane (18) and that the printed circuit board (17) is arranged in the housing (2) in such a manner that the printed circuit board plane (18) is arranged at an angle (a) to the orientation plane (16), the angle differing from an integral multiple of 90°.

7. Measuring device (1) according to claim 9, **characterized in that** the sensor access (14) leads into a connection plane (19), and that the printed circuit board (17) is arranged in the housing (2) in such a manner that the printed circuit board plane (18) is arranged at an angle to the connection plane (19), the angle differing from an integral multiple of 90°.

## Revendications

1. Appareil de mesure (1), comportant au moins un boîtier (2) et au moins deux dispositifs électroniques (3, 4), dans lequel le boîtier (2) comporte au moins deux chambres (8, 9) entre lesquelles se trouve un passage (10), dans lequel l'un des deux dispositifs électroniques (3, 4) est disposé dans chaque chambre (8, 9), et dans lequel un élément de contact (5) est disposé dans le passage (10),
dans lequel l'élément de contact (5) est réalisé séparément des dispositifs électroniques (3, 4) et du boîtier (2), dans lequel l'élément de contact (5) est disposé entre les deux dispositifs électroniques (3, 4), et dans lequel l'élément de contact (5) comporte au moins un élément de transmission électronique (6) destiné à créer une liaison électrique entre les deux dispositifs électroniques (3, 4),
**caractérisé en ce qu'**il est prévu plusieurs éléments de transmission (6) qui sont réalisés sous la forme de broches de contact, et **en ce que** les éléments de transmission (6) sont coulés et/ou émaillés à l'intérieur d'une paroi extérieure (7) de l'élément de contact (5), de sorte que l'élément de contact (5) est encapsulé sous la forme d'un composant autonome, permettant ainsi de fixer les distances minimales, entre les broches de contact, qui sont nécessaires pour un mode de protection prédéterminé à réaliser.

2. Appareil de mesure (1) selon la revendication l, **caractérisé en ce que** la paroi extérieure (7) est constituée au moins en partie d'acier inoxydable ou d'une matière plastique.

3. Appareil de mesure (1) selon la revendication 1 ou 2, **caractérisé en ce que** l'élément de contact (5) est réalisé sensiblement sous la forme d'un bouchon.

4. Appareil de mesure (1) selon l'une des revendications 1 à 3, **caractérisé en ce que** l'élément de contact (5) et les deux dispositifs électroniques (3, 4) sont réalisés et adaptés l'un à l'autre de telle manière que l'élément de contact (5) et les deux dispositifs électroniques (3, 4) soient reliés l'un à l'autre sensiblement sans interstice.

5. Appareil de mesure (1) selon l'une des revendications 1 à 4, **caractérisé en ce que** l'élément de contact (5) est en outre coulé dans le passage (10), et/ou **en ce que** la transition entre au moins un dispositif électronique (3, 4) et l'élément de contact (5) est coulée, et/ou **en ce qu'**au moins un dispositif d'étanchéité - en particulier un joint torique - est disposé entre au moins un dispositif électronique (3, 4) et l'élément de contact (5) et/ou entre l'élément de contact (5) et le passage (10).

6. Appareil de mesure (1) selon l'une des revendications 1 à 5, **caractérisé en ce que** le boîtier (2) comporte au moins un accès électronique (12) à au moins l'un des deux dispositifs électroniques (3, 4), dans lequel un premier axe longitudinal (13) s'étend à travers l'accès électronique (12), **en ce que** le boîtier (2) comporte un accès pour capteur (14) permettant le raccordement d'une unité à capteur (20), dans lequel un deuxième axe longitudinal (15) s'étend à travers l'accès pour capteur (14), et dans lequel le premier axe longitudinal (13) et le deuxième axe longitudinal (15) définissent un plan d'orientation (16), **en ce qu'**au moins un dispositif électronique (4) comporte au moins une carte (17), **en ce que** la carte (17) se situe sensiblement dans un plan de carte (18), et **en ce que** la carte (17) est disposée dans le boîtier (2) de telle manière que le plan de carte (18) soit disposé, par rapport au plan d'orientation (16), selon un angle (α) qui diffère d'un multiple entier de 90°.

7. Appareil de mesure (1) selon la revendication 6, **caractérisé en ce que** l'accès pour capteur (14) débouche dans un plan de raccordement (19), et **en ce que** la carte (17) est disposée dans le boîtier (2) de telle manière que le plan de carte (18) soit disposé, par rapport au plan de raccordement (19), selon un angle qui diffère d'un multiple entier de 90°.
